# EUROPÄISCHE PATENTSCHRIFT

(11) **EP 1 522 095 B1**
(45) Veröffentlichungstag und Bekanntmachung des Hinweises auf die Patenterteilung: **22.03.2006**
(21) Anmeldenummer: 03732528.9
(22) Anmeldetag: 04.06.2003
(51) Int. Cl.: H01L 21/60

(54) **VERFAHREN ZUR HERSTELLUNG EINES BAUELEMENTES MIT TIEFLIEGENDEN ANSCHLUSSFLÄCHEN**
METHOD FOR PRODUCING A COMPONENT HAVING SUBMERGED CONNECTING AREAS
PROCEDE DE PRODUCTION D'UN COMPOSANT A SURFACES DE CONNEXION PROFONDES

(30) Priorität: 16.07.2002 DE 10232190
(43) Veröffentlichungstag der Anmeldung: 13.04.2005
(73) Patentinhaber: austriamicrosystems AG, 8141 Unterpremstätten (AT)
(72) Erfinder: BRANDL, Manfred, A-8112 Gratwein (AT); CSERNICSKA, Robert, A-8510 Stainz (AT); DRAXLER, Walter, A-8430 Neutillmitsch (AT)
(74) Vertreter: Epping - Hermann - Fischer
(86) Internationale Anmeldenummer: PCT/EP2003/005859
(87) Internationale Veröffentlichungsnummer: WO 2004/008522

(56) Entgegenhaltungen:
- WO-A-01/46664
- US-A- 5 668 033
- US-A- 5 895 233
- US-B1- 6 407 381
- PATENT ABSTRACTS OF JAPAN vol. 1998, no. 09, 31. Juli 1998 (1998-07-31) -& JP 10 112548 A (DENSO CORP), 28. April 1998 (1998-04-28) -& US 6 555 901 B1 (YOSHIHARA SHINJI ET AL) 29. April 2003 (2003-04-29)

## Beschreibung

Die Erfindung betrifft ein Verfahren zur Herstellung tiefliegender bondbarer Anschlußflächen bei einem Bauelement, welches zumindest zwei miteinander verbundene Substrate umfaßt.

Aus der Druckschrift WO 98/05935 Al ist bekannt, daß Sensoren so auf ein Substrat aufgebracht werden können, daß die Sensorelemente über einer Öffnung im Substrat angeordnet sind. Aus der Druckschrift JP 2000195827 A bzw. dem Zitat in Patent Abstracts of Japan ist bekannt, auf einer Seite eines Substrats Gräben einzubringen und zur Vereinzelung der auf einem Wafer ausgebildeten LED-Bauelemente von der Rückseite des Substrats her über den Gräben Einschnitte bis zu einer solchen Tiefe zu erzeugen, daß die Gräben geöffnet werden. Aus der Druckschrift JP 09223678 A ist bekannt, daß bei zwei miteinander verbundenen Substraten zur Vereinzelung der Bauelemente Ausschnitte aus einem zweiten Substrat entfernt werden.

Bauelemente, die in zwei miteinander verbundenen Substraten realisiert sind, sind beispielsweise sogenannte COC (chip on chip) Bauelemente, die eine Art vertikaler Integration aufweisen. Die beiden Substrate, die beide Bauelementstrukturen aufweisen können, werden über zwei Hauptoberflächen miteinander verbunden, wobei gleichzeitig, falls erforderlich, ein elektrischer Kontakt zwischen Bauelementstrukturen in unterschiedlichen Substraten hergestellt werden kann. Das Bauelement kann gemeinsame oder getrennte elektrische Kontakte für beide verbundene Substrate aufweisen. Sind auf beiden Substraten elektrische Kontakte vorgesehen, so kann die wechselseitige elektrische Verbindung der in den beiden Substraten realisierten Bauelementstrukturen auch über Bonddrähte zwischen den jeweiligen Kontakte erfolgen.

Die COC-Technologie wird insbesondere zur Verkapselung von Bauelementen auf Chip Ebene eingesetzt, auch "first level packaging" genannt. Sie wird auch da verwendet, wo eine weitere Miniaturisierung der Bauelemente angestrebt wird und insbesondere Bauelemente mit vermindertem Flächenbedarf auf einer Platine oder in einem Modul gesucht werden. Die Technologie wird insbesondere angewandt zur Herstellung von ICs, mikromechanischen Bauelementen oder Sensoren (MEMS) oder auch zur Herstellung mikrooptischer Bauelemente.

Die Substrate der COC-Bauelemente werden üblicherweise mittels integrierter Verfahren auf Wafer-Ebene hergestellt, wobei auch die Verbindung der beiden Bauelementsubstrate auf Wafer-Ebene erfolgt. Es ist daher erforderlich, auf dem unteren der beiden Substrate, oder, bei mehreren Substraten, auf einem unteren Substrat nach dem Verbinden der beiden Substrate die elektrischen Anschlußflächen freizulegen und dazu beispielsweise ein Fenster in dem oberen Substrat zu erzeugen. Wird das Fenster nach dem Verbinden der beiden Substrate erzeugt, so besteht die Gefahr, daß durch den Fensteröffnungsprozeß zur Freilegung der Kontakte (Anschlußflächen) diese oder andere Strukturen auf dem unteren der beiden Substrate beschädigt oder gar zerstört werden.

Dokument US-A-5668033 beschreibt ein solches Verfahren wobei zwei Wafer zusammen gebondet und Anschlussflächen in dem Bauelemente umfassenden Wafer freigelegt werden durch Entfernung von Auschnitten im obenliegenden Wafer. Jeder Ausschnitt wird durch zwei Einschnitte mit einer Waferschneidesäge erzeugt.

Bekannt und üblich ist es daher, die Fenster, in denen die Anschlußflächen freiliegen, im oberen der beiden Wafer vor dem Verbinden der Substrate auszubilden. Bei Halbleiterwafern kann das beispielsweise durch anisotropes Ätzen von einer oder zwei Seiten des oberen Wafers erfolgen. Als Ätztechnik kann beispielsweise reaktives Ionenätzen eingesetzt werden. Nachteilig an dem Verfahren ist jedoch, daß das obere Substrat durch die vorgefertigten Fenster instabil wird, da mit den Fenstern mögliche Bruchstellen bereits vorgegeben sind. Dies ist insbesondere für das Verbinden der beiden Wafer von Nachteil, welches insbesondere unter Druck erfolgt. Dies hat zur Folge, daß die COC-Technologie, bei der zwei Substrate durch Bonden miteinander verbunden werden, auf der Wafer-Ebene auf Wafer von vier bis maximal sechs Zoll Durchmesser beschränkt ist. Ein weiterer Nachteil dieses Verfahrens ist, daß das ortsgenaue Durchätzen der Fenster einen hohen Zeit- und Verfahrensaufwand erfordert.

Aufgabe der vorliegenden Erfindung ist es daher, insbesondere für die COC-Technologie ein Verfahren anzugeben, welches eine einfachere Freilegung tiefliegender Anschlußflächen bei Bauelementen ermöglicht, die zumindest zwei miteinander verbundene Substrate umfassen.

Diese Aufgabe wird erfindungsgemäß durch ein Verfahren mit den Merkmalen von Anspruch 1 gelöst. Vorteilhafte Ausgestaltungen der Erfindung gehen aus weiteren Ansprüchen hervor.

Im Gegensatz zu dem bekannten Verfahren, bei dem die Fenster im oberen Substrat vor dem Verbinden der beiden Substrate durch Ätzen in einem aufwendigen Schritt erzeugt werden, wird die Freilegung der Anschlußflächen erfindungsgemäß in zwei Schritten durchgeführt.

Ein erster Schritt, der vor dem Verbinden der Substrate durchgeführt wird, besteht in dem Erzeugen von Gräben in der Oberfläche des zweiten (oberen) Substrats. Diese Gräben definieren und begrenzen einen Ausschnitt, in dem später die Anschlußflächen des ersten bzw. unteren Substrats freigelegt werden. Die Gräben werden bis zu einer vorgegebenen Tiefe erzeugt, die nur einem Bruchteil der gesamten Substratdicke entspricht.

Das erste Substrat, das auf seiner Oberfläche die genannten Anschlußfläche für im ersten Substrat angeordnete Bauelementstrukturen aufweist, wird anschließend so mit dem zweiten (oberen) Substrat verbunden, daß die Oberfläche des zweiten Substrats mit den Gräben zu der die Anschlußflächen aufweisenden Oberfläche des ersten Substrat weist.

Anschließend werden von der Rückseite des zweiten oberen Substrats her im Bereich über den Gräben Einschnitte erzeugt, die bis zu einer solchen Tiefe reichen, daß in den Einschnitten die Gräben über ihre gesamte Länge geöffnet werden. Vorzugsweise werden die Einschnitte dazu parallel zu den Gräben bzw. direkt über den Gräben und dem Verlauf der Gräben folgend erzeugt.

Das erfindungsgemäße Verfahren hat den Vorteil, daß die Stabilität des oberen Wafers durch die nur geringe Tiefe der Gräben eine ausreichende Stabilität behält, die gegenüber dem bekannten Verfahren das Risiko eines Substrat- oder Waferbruchs erheblich erniedrigt. Des weiteren hat das Verfahren den Vorteil, daß der aufwendigere Teilschritt des Verfahrens, nämlich das Erzeugen der Gräben, wegen deren geringen Tiefe wesentlich schneller und weniger aufwendig durchgeführt werden kann. Das Erzeugen der Einschnitte von der Rückseite dagegen kann nun mit einem kostengünstigeren, einfacheren und gegebenenfalls unpräziseren Verfahren erfolgen, beispielsweise durch Einsägen.

Nach dem Öffnen der Gräben in den Einschnitten ist das zweite Substrat im Bereich des Ausschnitts durchtrennt, so daß der Ausschnitt entfernt werden kann, wobei das gewünschte Fenster entsteht, in dem die Anschlußflächen freigelegt sind.

Wird zum Erzeugen der Einschnitte ein Sägeverfahren eingesetzt und beispielsweise eine Diamantsäge verwendet, so ist es von Vorteil, die Einschnitte als geradlinige Schnitte zu erzeugen. Dementsprechend werden auch gradlinige Gräben in der gegenüberliegenden Oberfläche des zweiten Substrats vorgesehen. Dazu passend werden vorzugsweise die Anschlußflächen in einer Reihe nebeneinander angeordnet, so daß sich mit einem einzigen Ausschnitt bzw. mit zwei Einschnitten ein langgestrecktes, über das gesamte Substrat reichendes Fenster öffnen läßt, in dem eine oder mehrere Reihe von Anschlußflächen in einem Schritt freigelegt werden können. Eine Reihe von Anschlußflächen kann zu einem oder mehreren, nebeneinander auf dem ersten Substrat angeordneten Bauelementen gehören.

Die Herstellung der Gräben kann in einem beliebigen Verfahren erfolgen, welches strukturiert und kontrolliert so durchgeführt werden kann, daß ortsgenaue Gräben einer gewünschten Grabentiefe erzeugt werden können. Möglich ist es beispielsweise, die Gräben über eine Resist-Maske zu definieren, die photolithographisch strukturiert wird. Mit der Resist-Maske wird anschließend ein strukturierter Ätzprozeß durchgeführt, bei dem in den nicht von der Resist-Maske bedeckten Bereichen Material entfernt wird, bis eine gewünschte oder vorgegebene Grabentiefe erreicht ist. Als Ätzverfahren kann naßchemisches Ätzen, Ionenstrahlätzen oder plasmaunterstütztes Ätzen verwendet werden. Das Ätzen kann isotrop oder anisotrop erfolgen, da Grabenprofil und Grabenbreite nahezu keinen Einfluß auf die Qualität des mit dem erfindungsgemäßen Verfahren erzeugten Bauelement haben. Trotzdem sind anisotrope Verfahren bevorzugt, da in solchen Verfahren weniger Material entfernt werden muß, was den Aufwand für den Ätzprozeß verringert.

Die Breite der Gräben hat deswegen keinen Einfluß auf das Verfahrensergebnis, da die Gräben lediglich zur Definition zur Ausschnitts dienen und da in den Gräben lediglich eine Auftrennung des Substrats bis zur Grabentiefe erfolgen muß. Von Vorteil ist eine solche Grabenbreite, die ein sicheres Auftrennen bis zur gewünschten Tiefe erzeugt, damit nach dem Herstellen der Einschnitte keine Materialbrücken zwischen dem Ausschnitt und dem verbleibenden Substrat bestehen bleiben.

Vorteilhafterweise werden Maßnahmen vorgesehen, die ein leichtes Ablösen bzw. das vollständige Entfernen des Ausschnitts, also des Bereichs des zweiten Substrats, der zwischen den Gräben definiert ist und der das Fenster zum Freilegen der Anschlußflächen bildet, gewährleisten. Eine Möglichkeit dazu besteht darin, über den Anschlußflächen einen Freiraum vorzusehen, der auch nach dem Verbinden der beiden Substrate für einen lichten Abstand zwischen Anschlußflächen und der benachbarten Oberfläche des zweiten Wafers sorgt. Zur Gewährleistung eines solchen lichten Abstands kann in zumindest einem der beiden Substrate auf einer der zueinander weisenden Oberflächen eine Struktur erzeugt werden, die als Abstandshalter jenseits des Fensters dient. Möglich ist es auch, unter den Anschlußflächen im ersten Substrat oder über den Anschlußflächen im zweiten Substrat eine entsprechende Vertiefung vorzusehen.

Eine weitere Möglichkeit, das vollständige Entfernen des Ausschnitts zu erleichtern, besteht darin, über den Anschlußflächen im Bereich des Ausschnitts eine Abdeckung vorzusehen, die beim Verbinden der beiden Substrate ein direktes Anhaften des zweiten Substrats an den Anschlußflächen verhindert. Vorzugsweise verwendet man dazu solche Abdeckungen, die sich nach dem Öffnen des Ausschnitts leicht entfernen lassen und die daher keine oder eine nur geringe Haftung zu den beiden Substraten aufweisen sollten. Als Abdeckung geeignet sind daher insbesondere solche Schichten oder Schichtmaterialien, die nur geringe Adhäsionskräfte auf dem Substrat ausbilden oder die eine Schicht von nur geringem inneren Zusammenhalt erzeugen, so daß eine einfache Entfernung des Ausschnitts möglich ist.

Prinzipiell ist es auch möglich, solche Verfahren zum Verbinden der beiden Substrate einzusetzen, die gezielt und selektiv nur an gewünschten Verbindungsflächen zum Herstellen einer festen Verbindung zwischen den beiden Substraten führen. Dazu gehören insbesondere solche Verfahren, bei denen ein Verbindungsmaterial zum Herstellen der Verbindung auf eines der beiden Substrate aufgebracht wird. Dies sind beispielsweise Glasbonden, Bonden über Bumps, eudektisches Bonden und teilweise auch anodisches Bonden. Bei diesen Verbindungsverfahren ist es nicht erforderlich, einen lichten Abstand der beiden Substrate über den Anschlußflächen zu gewährleisten oder eine Abdeckschicht über den Anschlußflächen vorzusehen. Diese Verfahren können so durchgeführt werden, daß die Verbindungsstellungen beider Substrate außerhalb der für die Anschlußflächen vorgesehenen Oberflächen der Substrate erfolgt. Zum Verbinden der beiden Substrate ist auch ein Klebstoff geeignet sowie, wenn die Substrate Halbleitermaterial umfassen, ein Direktbonden dieser Halbleitermaterialien. Dazu werden diese hoher Temperatur ausgelagert, wobei eine feste Verbindung der dabei miteinander in Kontakt tretenden Halbleiteroberflächen erzeugt wird.

Im Folgenden wird die Erfindung anhand von Ausführungsbeispielen und der dazugehörigen Figuren näher erläutert. Die Figuren stellen nur schematische Darstellungen dar, sind nicht maßstabsgetreu ausgeführt und können die Erfindung nur auszugsweise anhand der speziellen Ausführungsbeispiele wiedergeben.
- Figur 1: zeigt ein bekanntes COC-Bauelement im schematischen Querschnitt,
- Figur 2: zeigt zwei zu verbindende Substrate im schematischen Querschnitt,
- Figur 3: zeigt die Anordnung der Gräben auf dem zweiten Substrat,
- Figur 4: zeigt das Bauelement während der Herstellung der Einschnitte im schematischen Querschnitt,
- Figur 5: zeigt das Bauelement nach den Einschnitten,
- Figur 6: zeigt die auf dem ersten Substrat freigelegten Anschlußflächen in der Draufsicht,
- Figur 7: zeigt ein Einzelbauelement nach Vereinzelung.

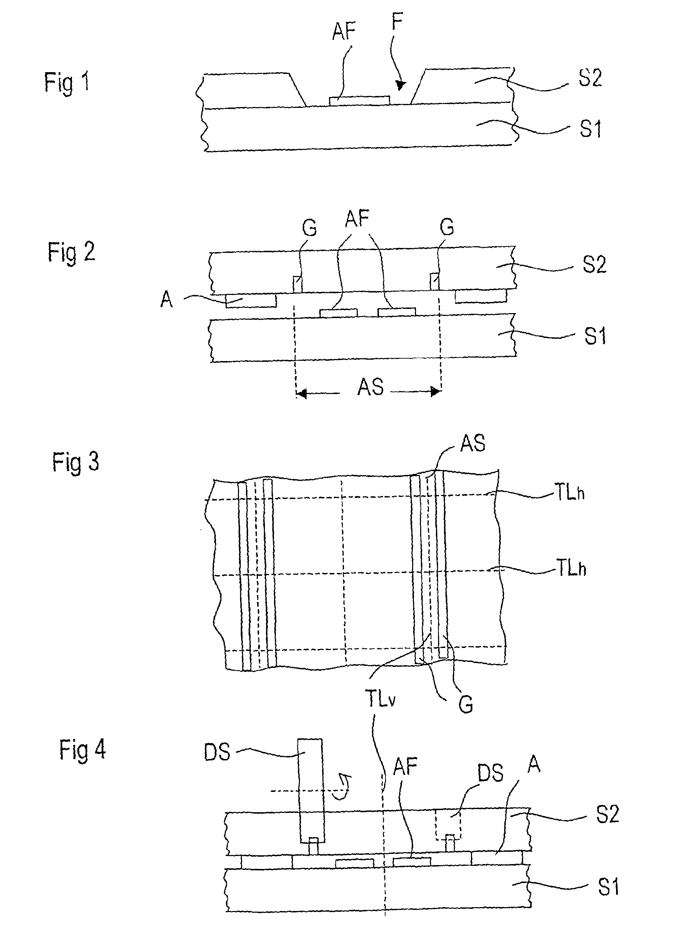

In Figur 1 ist ein an sich bekanntes Chip-on-Chip-Bauelement im schematischen Querschnitt dargestellt. Das Bauelement ist aus einem ersten Substrat S1 und einem damit verbundenen zweiten Substrat S2 aufgebaut, die mit an sich bekannten Bondtechnologien verbunden sind. Zumindest das untere erste Substrate S1 enthält Bauelementstrukturen, deren elektrischer Anschluß zur Außenwelt über die Anschlußfläche AF auf der Oberseite des unteren Substrats S1 erfolgt. Damit dieses in dem Zweischicht-Bauelement von außen zugänglich ist, weist das zweite Substrat S2 im Bereich der Anschlußfläche AF ein Fenster auf, in dem die Anschlußfläche AF freigelegt ist. Das Fenster im zweiten Substrat S2 wird vor dem Verbinden der beiden Substrate mittels Ätztechnologien erzeugt.

Figur 2: Gemäß der Erfindung wird in einem aus zumindest einem ersten Substrat S1 und einem zweiten Substrat S2 bestehenden Bauelement wie folgt vorgegangen. Im zweiten Substrat S2 werden mit einer Ätztechnik Gräben G erzeugt. Zwischen zwei gradlinigen Gräben oder innerhalb einer kreisförmig geschlossenen Grabenstruktur wird ein Ausschnitt AS definiert, der der Größe des später zu öffnenden Fensters entspricht. Auf der Oberfläche des ersten Substrats S1 sind Anschlußflächen AF vorgesehen, beispielsweise lötfähige Kontakte. Zumindest eines der beiden Substrate weist auf einer der zu verbindenden Oberflächen eine Abstandsstruktur A auf, welche im vorliegenden Fall beispielsweise die Verbindungsstelle zwischen den beiden Substraten S1 und S2 darstellt. Die Abstandsstruktur A kann beispielsweise ein Bump, eine Metallisierung zum eutektischen Bonden oder ein Klebstoffauftrag sein. Die Abstandsstruktur A kann durch Strukturieren der Oberfläche eines der Substrate erfolgen. Dazu wird eine der Substratoberflächen durch Ätzen so strukturiert, daß an den zum Bonden vorgesehenen Stellen ein geeignetes höheres Niveau gegenüber der restlichen Substratoberfläche entsteht.

Figur 3 zeigt das Substrat S2 in der Draufsicht auf die Oberfläche, in der die Gräben G angeordnet sind. In dem Substrat, in dem mehrere Einzelbauelemente realisiert sind, sind die Grenzen zwischen den zukünftigen Einzelbauelemente durch gestrichelte Trennlinien TLₕ und TLᵥ gekennzeichnet. Die Gräben G verlaufen vorzugsweise gradlinig über das gesamte Substrat und sind paarweise so angeordnet, daß sie einen streifenförmigen Ausschnitt AS zwischen sich definieren. Der streifenförmige Ausschnitt AS ist vorzugsweise direkt über einer Trennlinie TLᵥ angeordnet, so daß der Ausschnitt AS die Randbereiche von jeweils zwei benachbarten Einzelbauelementen überdeckt. Mit der in Figur 3 dargestellten Strukturierung wird in jedem Einzelbauelement nur ein streifenförmiger Ausschnitt AS erzeugt. Möglich ist es jedoch auch, zwei und mehr dieser Ausschnitte pro Einzelbauelement zu erzeugen, wenn eine höhere Anzahl von Anschlußflächen darin freizulegen ist.

Nach dem Erzeugen der Gräben G werden die beiden Substrate S1 und S2 nach einem an sich bekannten Verfahren, insbesondere einem Wafer-Bondverfahren oder durch Kleben, miteinander verbunden. In dem in der Figur 4 dargestellten Beispiel erfolgt die Verbindung über die Strukturen A. Möglich ist es jedoch auch, die Verbindung beider Substrate großflächig vorzunehmen und dazu insbesondere die Anschlußflächen AF in einer Vertiefung anzuordnen. Möglich ist es auch, im zweiten Substrat S2 über den Anschlußflächen AF eine Vertiefung vorzusehen.

Mit Hilfe einer Säge, beispielsweise einer Diamantsäge DS, die in der Figur nur schematisch als rotierende Scheibe dargestellt ist, wird nun von der den Gräben gegenüberliegenden Rückseite des zweiten Substrats S2 her ein Einschnitt ES über den Gräben G erzeugt. Der Einschnitt ES wird bis zu einer solchen Tiefe geführt, bis der jeweilige Graben von der Rückseite her geöffnet ist. Auf diese Weise wird das zweite Substrat S2 parallel zu den Gräben vollständig aufgetrennt.

Die zweistufige Durchführung der Auftrennung hat den Vorteil, daß die Erzeugung der Einschnitte mit einem wesentlich ungenaueren Werkzeug vorgenommen werden kann, welches alleine wegen der relativ hohen Abweichung bezüglich der Einschnitttiefe zur Durchführung der Auftrennung nicht einsetzbar wäre. Zur Bemessung der Grabentiefe ergibt sich daher als Untergrenze, daß die Grabentiefe zumindest dem Toleranzwert entsprechen sollte, der dem Werkzeug zur Erzeugung der Einschnitte, insbesondere der Diamantsäge DS, entspricht. Sofern aufgrund einer besonderen Ausgestaltung der Oberflächentopologie der beiden Substrate auf der Verbindungsseite zwischen der Oberkante der Gräben im zweiten Substrat und der darunterliegenden Oberfläche des ersten Substrats ein ausreichender lichter Abstand gegeben ist, kann die Tiefe des Grabens um diesen Betrag vermindert werden. Hochwertige heutzutage verwendete Diamantsägen DS weisen eine Toleranz bezüglich der Einschnitt-Tiefe von mehr als 20 *µ*m, üblicherweise 50 - 60 *µ*m, auf. Daraus folgt, daß die Tiefe der Gräben vorzugsweise dem höchsten einzuhaltenden Toleranzwert der Säge entspricht. Wenn beide Substrate S1, S2 Halbleiterwafer darstellen, die beispielsweise eine Dicke von 500 *µ*m aufweisen, so beträgt die erforderliche Grabentiefe für die genannten hochwertigen Sägen beispielsweise nur ca. 10 % der Schichtdicke. Dies führt zu einer nur unwesentlichen Beeinträchtigung der Stabilität des Wafers. Die höhere mechanische Stabilität der erfindungsgemäßen Substrate S ermöglicht es dann, zur Herstellung von COC-Bauelementen oder besser allgemein von stacked Wafer-Bauelementen größere Wafer einzusetzen, ohne daß eine höhere Bruchgefahr während des Herstellungs- und Bearbeitungsverfahrens, insbesondere beim Wafer-Bonden zu befürchten ist. Der zweite Einschnitt ES ist in der Figur nur durch gestrichelte Linien dargestellt.

Aus der Figur ergibt sich direkt ein weiterer Vorteil des erfindungsgemäßen Verfahrens. Die Schnittbreite bei der Herstellung der Einschnitte kann beliebig groß gewählt werden, wodurch sich die Justierung der Einschnitte relativ zu den Gräben erleichtert. Möglich ist es sogar, zur Herstellung der Einschnitte ein Werkzeug zu verwenden, dessen Schnittbreite der Breite des Ausschnitts, also der Entfernung der Gräben voneinander, entspricht. Auf diese Weise genügt für einen Ausschnitt ein einziger Einschnitt, um das Fenster zur Freilegung der Anschlußflächen AF zu öffnen. Die genannten Diamentsägen DS haben jedoch üblicherweise nur eine Schnittbreite von ca. 30 - 100 *µ*m, während eine nach heutiger Drahtbondtechnik ausreichende Breite des Ausschnitts AS zumindest 0,5 mm betragen sollte, vorzugsweise jedoch 1 bis 3 mm.

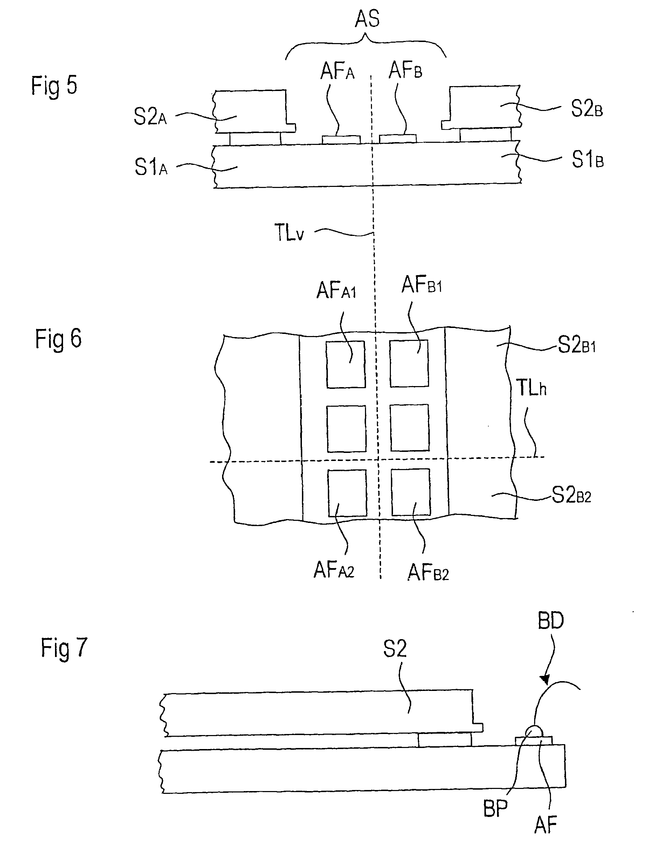

Nach dem Fertigstellen der Einschnitte ist der dem Ausschnitt AS entsprechende Substratstreifen völlig vom restlichen substrat S2 gelöst und kann entfernt werden. In dem dadurch entstehenden Fenster F sind, wie in Figur 5 im schematischen Querschnitt dargestellt, nun die Anschlußflächen AF freigelegt und aufgrund der geeigneten Breite des Ausschnitts AS für einen Lötvorgang gut zugänglich. In der Figur sind im Fenster F zwei Anschlußflächen angeordnet, die unterschiedlichen Bauelementen zugehörig sind und entsprechend durch Indizes A und B gekennzeichnet sind. Die Trennlinie TLᵥ, entlang der später die beiden Bauelemente getrennt werden, ist durch gestrichelte Linien eingezeichnet.

Figur 6 zeigt die Anordnung in dieser Verfahrensstufe in der Draufsicht. Im gewählten Ausschnitt des insgesamten größeren Bauelementes ist eine Kreuzung zweier Trennlinien TLᵥ, TLₕ angeordnet, so daß hier die aneinanderstoßenden Ecken vierer Einzelbauelemente dargestellt sind. Pro Einzelbauelement kann eine beliebige, vom Bauelementtyp abhängige Anzahl von Anschlußflächen AF vorgesehen sein. Pro Wafer (Substrat) kann eine im Wesentlichen von der Größe der Einzelbauelemente begrenzte, ansonsten aber beliebige Anzahl Einzelbauelemente vorgesehen sein.

Auf dieser Stufe ist es nun bereits möglich, die Einzelbauelemente auf ihre Funktionsfähigkeit hin zu testen und dazu insbesondere die Anschlußflächen AF mit entsprechenden Kontakten zu versehen. Möglich ist es jedoch auch, die Bauelemente direkt zu vereinzeln. Dies kann in zwei Stufen erfolgen, wobei die Anordnung mit Hilfe eines geeigneten Trennwerkzeugs, beispielsweise der genannten Diamantsäge, entlang den Trennlinien TL einer Sorte, beispielsweise TLᵥ, zu einzelnen Streifen aufgeteilt werden, wobei jeder Streifen eine Reihe von miteinander verbundenen Bauelementen enthält. Auch auf dieser Stufe kann der elektrische Test der Einzelbauelemente erfolgen, bevor abschließend die Auftrennung in Einzelbauelemente entlang der zweiten Trennlinien TLₕ erfolgt.

Figur 7 zeigt ausschnittsweise ein Einzelbauelement nach dem Vereinzeln. Gut zu erkennen ist, daß die Anschlußflächen AF im Randbereich des jeweiligen Bauelements bzw. dessen ersten Substrats benachbart sind. Weiterhin ist dargestellt, wie die Anschlußflächen mit Hilfe einer metallischen Verbindung, beispielsweise eines Bumps BP mit einem Bonddraht BD verbunden und nach außen kontaktiert werden, beispielsweise auf einer Platine. Die Anordnung der Anschlußflächen AF am Rand hat den Vorteil, daß der Bonddraht berührungsfrei von den Kanten des zweiten Substrats S2 geführt werden kann. Sind auf dem zweiten Substrat S2 weitere Kontakte für Bauelementstrukturen innerhalb des zweiten Substrats vorgesehen, so wird hiermit die Gefahr eines ungewollten Kurzschlusses ausgeschlossen.

Mit Hilfe des erfindungsgemäßen Verfahrens können die tiefliegenden Anschlußflächen verschiedenster Bauelemente freigelegt werden, die während der Herstellung unter zwei großflächig miteinander verbundenen Substraten ursprünglich verdeckt waren. Dementsprechend kann das Bauelement in nur einem Substrat, insbesondere im ersten Substrat S1, ausgebildet sein und das zweite Substrat S2 daher beispielsweise eine Abdekkung für das Bauelement darstellen. In allen Fällen handelt es sich bei den beiden Substraten um keramische, glasartige oder kristalline, in jedem Fall aber starre, großflächige feste Körper. In Hohlräumen, die zwischen den beiden Substraten S1 und S2 gebildet sein können, kann außerdem ein Vakuum oder eine beliebige Gasatmosphäre eingeschlossen sein. Zumindest eines der beiden Substrate kann außerdem mikromechanische oder mikrooptische Bauelementstrukturen aufweisen. Vorzugsweise ist das Bauelement daher ein IC, ein Sensor, ein MEMS Sensor für Druck, Beschleunigung oder Drehrate, ein mikrooptisches Bauelement wie beispielsweise eine Photosensorarray mit einer Glasabdeckung oder ein beliebiges anderes, zwei miteinander verbundene Substrate umfassendes Bauelement.

In einer nicht dargestellten weiteren Ausführungsform der Erfindung weist das Bauelement einen aus mehr als zwei übereinandergestapelten Substraten bestehenden Aufbau auf. Das dritte und weitere Substrate können auf der Oberfläche des ersten oder des zweiten Substrats aufgebracht sein. Vorzugsweise werden die weiteren Substrate zwischen den in den Figuren 2 und 4 dargestellten Verfahrensstufen mit einem der beiden anderen Substrate oder dem Verbund der beiden Substrate verbunden. Ein ganzflächig auf dem zweiten Substrat S2 aufliegendes drittes oder weiteres Substrat kann erfindungsgemäß zusammen mit dem zweiten Substrat eine Einheit bilden, die wie ein einziges zweites Substrat behandelt wird und beim Herstellen der Einschnitte ES vollständig durchtrennt wird.

## Patentansprüche

1. Verfahren zur Herstellung von tief liegenden bondbaren Anschlußflächen (AF) bei einem zumindest zwei miteinander verbundene Substrate (S1,S2) umfassenden Bauelement,
- bei dem ein erstes, elektrisch leitende Bauelementstrukturen umfassendes Substrat (S1) vorgesehen wird, wobei die Bauelementstrukturen mit den genannten Anschlußflächen (AF), die auf einer Oberfläche des ersten Substrats (S1) angeordnet sind, elektrisch verbunden sind,
- bei dem ein zweites Substrat (S2) vorgesehen wird,
- bei dem in der Oberfläche des zweiten Substrats (S2) mittels einer ersten Technik Gräben (G) mit einer vorgegebenen Tiefe geradlinig so erzeugt werden, dass sie jeweils paarweise einen streifenförmigen Ausschnitt (AS) zwischen sich definieren,
- bei dem das erste und das zweite Substrat so miteinander verbunden werden, daß die mit den Anschlußflächen und den Gräben versehenen Oberflächen der beiden Substrate zueinander weisen,
- bei dem von der nun außen liegenden Rückseite des zweiten Substrats her mittels einer zweiten Technik über den Gräben Einschnitte (ES) bis zu einer solchen Tiefe erzeugt werden, daß dort die Gräben (G) geöffnet werden, wobei die erste Technik von der zweiten Technik verschieden ist und eine höhere Genauigkeit aufweist als die zweite Technik
- bei dem der zumindest eine Ausschnitt (AS) entfernt wird, wobei die Anschlussflächen (AF) freigelegt werden.

2. Verfahren nach Anspruch 1,
bei dem die Gräben (G)und die den Gräben folgenden Einschnitte (ES) geradlinig über das gesamte zweite Substrat (S2) verlaufend hergestellt werden, bei dem die Einschnitte durch Sägen erzeugt werden, und bei dem zwischen jeweils zwei Gräben ein Ausschnitt (AS) zum Freilegen der Anschlußflächen (AF) definiert ist.

3. Verfahren nach Anspruch 2,
bei dem jeweils mehrere Anschlußflächen (AF) des ersten Substrats (S1) in einer Reihe nebeneinander angeordnet werden und bei dem jeweils einer der Ausschnitte (AS) eine der Reihen von Anschlußflächen (AF) freilegt.

4. Verfahren nach einem der Ansprüche 1 bis 3,
bei dem die Gräben (G) durch naßchemisches Ätzen, Ionenstrahl- oder Plasmaätzen erzeugt werden.

5. Verfahren nach Anspruch 4,
bei dem die Gräben (G) über eine Resistmaske definiert werden, die photolithographisch strukturiert wird.

6. Verfahren nach einem der Ansprüche 1 bis 3,
bei dem die Gräben (G) durch Laserschneiden erzeugt werden.

7. Verfahren nach einem der Ansprüche 1 bis 6,
bei dem die Gräben (G) bis zu einer Tiefe erzeugt werden, die größer ist, als die Schnittiefengenauigkeit des Sägeverfahrens beim Erzeugen der Einschnitte (ES).

8. Verfahren nach einem der Ansprüche 1 bis 7,
bei dem vor dem Verbinden der Oberflächen der beiden Substrate (S1,S2) zumindest eine der Oberflächen so ausgebildet wird, daß nach dem Verbinden über den Anschlußflächen (AF) ein lichter Freiraum mit Abstand zur entsprechenden Oberflächen des zweiten Substrats (S2) geschaffen wird.

9. Verfahren nach einem der Ansprüche 1 bis 7,
bei dem vor dem Verbinden der Oberflächen auf dem ersten Substrat (S1) zumindest über den Anschlußflächen (AF) oder unter dem späteren Ausschnitt (AS) des zweiten Substrats (S2) eine Abdeckung erzeugt wird, so daß beim Verbinden ein direktes Anhaften des zweiten Substrats an den Anschlußflächen verhindert wird, und bei dem die Abdeckung nach dem Erzeugen des Ausschnitts wieder entfernt wird.

10. Verfahren nach einem der Ansprüche 1 bis 9,
bei dem das Verfahren zum Verbinden der Substrate (S1,S2) eines der folgenden Maßnahmen umfaßt: Glasbonden, Bonden über Bumps, Anodisches Bonden, Eutektisches Bonden, Direktbonden von aus Halbleitermaterial bestehenden Substratoberflächen oder Kleben.

11. Verfahren nach einem der Ansprüche 1 bis 10,
bei dem Wafer als Substrate (S1,S2) eingesetzt werden, wobei zumindest im ersten Substrat mehrere Bauelemente ausgebildet werden, die nach dem Freilegen der Anschlußflächen (AF) vereinzelt werden.

12. Verfahren nach Anspruch 11,
bei dem die Anschlußflächen (AF) jedes Bauelements in Reihen angeordnet werden, die zu Kanten des einzelnen Bauelements direkt benachbart sind, wobei die Reihen direkt benachbarter Bauelemente nebeneinander verlaufen und
bei dem in einem Ausschnitt (AS) jeweils die zwei benachbarten Reihen von Anschlußflächen benachbarter Bauelemente frei gelegt werden.

13. Verfahren nach einem der Ansprüche 1 bis 12,
bei dem in zumindest einem der Substrate (S1,S2) mikroelektrische, miktrooptische oder mikromechanische Bauelemente oder kombinierte Bauelemente der genannten Typen realisiert werden.

## Claims

1. Method for producing deeply situated bondable connecting areas (AF) in a component comprising at least two substrates (S1, S2) that are connected to one another,
- in which a first substrate (S1) comprising electrically conductive component structures is provided, the component structures being electrically connected to the said connecting areas (AF), which are arranged on a surface of the first substrate (S1),
- in which a second substrate (S2) is provided,
- in which trenches (G) having a predetermined depth are produced rectilinearly in the surface of the second substrate (S2) by means of a first technique such that they define between themselves in each case in pairs a strip-type excision (AS),
- in which the first and second substrates are connected to one another in such a way that those surfaces of the two substrates which are provided with the connecting areas and the trenches face one another,
- in which, from the now exterior rear side of the second substrate, incisions (ES) are produced by means of a second technique above the trenches down to a depth such that the trenches (G) are opened there, the first technique being different from the second technique and having a higher accuracy than the second technique,
- in which the at least one excision (AS) is removed, the connecting areas (AF) being uncovered.

2. Method according to Claim 1,
in which the trenches (G) and the incisions (ES) following the trenches are produced in a manner running rectilinearly over the entire second substrate (S2), in which the incisions are produced by sawing, and in which an excision (AS) for uncovering the connecting areas (AF) is defined between in each case two trenches.

3. Method according to Claim 2,
in which a plurality of connecting areas (AF) of the first substrate (S1) are in each case arranged alongside one another in a row, and in which one of the excisions (AS) in each case uncovers one of the rows of connecting areas (AF).

4. Method according to one of Claims 1 to 3,
in which the trenches (G) are produced by wet-chemical etching, ion beam or plasma etching.

5. Method according to Claim 4,
in which the trenches (G) are defined by means of a resist mask that is patterned photolithographically.

6. Method according to one of Claims 1 to 3,
in which the trenches (G) are produced by laser cutting.

7. Method according to one of Claims 1 to 6,
in which the trenches (G) are produced down to a depth that is greater than the depth of cut accuracy of the sawing method during the production of the incisions (ES) .

8. Method according to one of Claims 1 to 7,
in which, before the surfaces of the two substrates (S1, S2) are connected, at least one of the surfaces is formed in such a way that a clearance with a distance to the corresponding surface of the second substrate (S2) is created above the connecting areas (AF) after the connection.

9. Method according to one of Claims 1 to 7,
in which, before the surfaces are connected, a covering is produced on the first substrate (S1) at least above the connecting areas (AF) or below the later excision (AS) of the second substrate (S2), so that direct adhering of the second substrate to the connecting areas is prevented during connection, and in which the covering is removed again after the production of the excision.

10. Method according to one of Claims 1 to 9,
in which the method for connecting the substrates (S1, S2) comprises one of the following measures: glass bonding, bonding by means of bumps, anodic bonding, eutectic bonding, direct bonding of substrate surfaces comprising semiconductor material, or adhesive bonding.

11. Method according to one of Claims 1 to 10,
in which wafers are used as substrates (S1, S2), a plurality of components being formed at least in the first substrate, said components being singulated after the connecting areas (AF) have been uncovered.

12. Method according to Claim 11,
in which the connecting areas (AF) of each component are arranged in rows that are directly adjacent to edges of the individual component, the rows of directly adjacent components running alongside one another, and
in which the two adjacent rows of connecting areas of adjacent components are in each case uncovered in an excision (AS).

13. Method according to one of Claims 1 to 12,
in which microelectrical, micro-optical or micromechanical components or combined components of the aforementioned types are realized in at least one of the substrates (S1, S2).

## Revendications

1. Procédé de fabrication d'une surface de connexion (AF), située en profondeur, susceptible d'être liée, pour un composant comprenant au moins deux substrats (S1, S2) reliés entre eux, dans lequel :
- on a prévu un premier substrat (S1) comprenant des structures de composants conductrices d'électricité; les structures de composant étant reliées électriquement avec les surfaces de connexion (AF) mentionnées, qui sont disposées sur une surface du premier substrat (S1),
- on a prévu un deuxième substrat (S2),
- on a effectué dans la surface du deuxième substrat (S2), au moyen d'une première technique, de façon rectiligne des tranchées (G) de profondeur prédéterminée, de manière à ce que lesdites tranchées définissent entre elles à chaque fois par paires une découpure (AS) en forme de bande,
- le premier et le deuxième substrat étant reliés ensemble de manière à ce que les surfaces des deux substrats pourvues des surfaces de connexion et des tranchées soient face à face,
- des coupes (ES) sont générées au moyen d'une deuxième technique à partir du côté arrière, qui est situé maintenant à l'extérieur, du deuxième substrat au dessus des tranchées jusqu'à atteindre une profondeur où les tranchées (G) s'ouvrent, la première technique étant différente de la deuxième technique et présentant une plus grande précision que la deuxième technique,
- au moins une découpure (AS) est retirée pour mettre à nu les surfaces de connexion.

2. Procédé selon la revendication 1,
dans lequel les tranchées (G) et les coupes (ES) suivant les tranchées sont réalisées de façon rectiligne sur la totalité du deuxième substrat (S2), dans lequel les coupes sont générées par un sciage, et dans lequel on a définit une découpure (AS) entre deux tranchées à chaque fois pour mettre à nu les surfaces de connexion.

3. Procédé selon la revendication 2,
dans lequel plusieurs surfaces de connexion (AF) du premier substrat (S1) sont disposées à chaque fois en une rangée côté à côte, et
dans lequel une des découpures (AS) met à nu une des rangées de surfaces de connexion (AF).

4. Procédé selon une des revendications 1 à 3, dans lequel les tranchées (G) sont générées par un décapage humide, des décapages à jets d'ions ou des décapages à plasma.

5. Procédé selon la revendication 4,
dans lequel les tranchées (G) sont définies par un masque à résistance qui est structurée de façon photolithographique.

6. Procédé selon une des revendications 1 à 3,
dans lequel les tranchées (G) sont générées par des coupes au laser.

7. Procédé selon une des revendications 1 à 6,
dans lequel les tranchées (G) sont générées jusqu'à une profondeur qui est supérieure à la précision de la profondeur de coupe du procédé de sciage lors de la production des coupes (ES).

8. Procédé selon une des revendications 1 à 7,
dans lequel avant la liaison des surfaces des deux substrats (S1, S2), au moins une des surfaces est formée afin de réaliser une cavité avec une distance par rapport à la surface correspondante du deuxième substrat (S2), après la liaison au dessus des surfaces de connexion (AF).

9. Procédé selon une des revendications 1 à 7,
dans lequel on génère un recouvrement avant la liaison des surfaces, sur le premier substrat (S1), au moins au dessus des surfaces de connexion (AF) ou sous la découpure (AS) suivante du deuxième substrat (S2), afin d'empêcher une adhésion directe du deuxième substrat sur les surfaces de connexion lors de la liaison, et
dans lequel le recouvrement est à nouveau retiré après la réalisation de la découpure.

10. Procédé selon une des revendications 1 à 9,
dans lequel le procédé comprend une des mesures suivantes pour relier les substrats (S1, S2) : liaison par vitrification, liaison par contacts surélevés , liaison anodique, liaison par diffusion, une liaison directe de surfaces de substrat composées de matériau semi-conducteur ou par collage.

11. Procédé selon une des revendications 1 à 10,
dans lequel on utilise des plaquettes en tant que substrats (S1, S2) ; où plusieurs dispositifs sont formés au moins dans le premier substrat, lesquels dispositifs sont séparés après la mise à nu des surfaces de connexion (AF).

12. Procédé selon la revendication 11,
dans lequel les surfaces de connexion (AF) de chaque dispositif sont disposées en rangées qui sont directement voisins des bords de chaque dispositif ; les rangées des dispositifs directement voisins s'étendent côte à côte, et dans lequel les deux rangées voisines des surfaces de connexion sont mises à nu à chaque fois dans une découpure (AS).

13. Procédé selon une des revendications 1 à 12,
dans lequel on a réalisé dans au moins une des substrats (S1, S2), des dispositifs du type micro-électriques, micro-optiques ou micro-mécaniques ou des dispositifs combinés du type cité.
